# EUROPEAN PATENT APPLICATION

(11) **EP 3 722 878 A1**
(43) Date of publication of application: **14.10.2020**
(21) Application number: 19888237.5
(22) Date of filing: 23.12.2019
(51) Int. Cl.: G03F 7/20

(54) **FAST SCAN EXPOSURE METHOD BASED ON DMD**

(30) Priority: 25.12.2018 CN 201811588156
(71) Applicant: Circuit Fabology Microelectronics Equipment Co., Ltd., Hefei, Anhui 230088 (CN)
(72) Inventor: BIAN, Hongfei, Hefei, Anhui 230088 (CN)
(74) Representative: Spittle, Mark Charles
(86) International application number: PCT/CN2019/127498
(87) International publication number: WO 2020/135343

(57) **Abstract**

A rapid scanning exposure method based on a DMD, includes the following operations: S100, controlling light emitted by the laser (11) to irradiate onto the DMD (12), to be reflected through the DMD (12) into the objective lens (13), and to be imaged on photosensitive material on the substrate (14) on the precision platform (15); S200, controlling the precision platform (15) to make a uniform motion in a first direction and to generate pulse signals equidistantly with a set scanning step, and to make a stepping motion or not make a motion in a second direction perpendicular to the first direction; S300, adjusting an angle of deflection of micro mirrors of the DMD after a pattern is refreshed when the DMD (12) detects the pulse signal and before a next pulse signal is detected, to reflect the light emitted by the laser outside the objective lens (13).

## Description

### FIELD

The disclosure relates to the field of maskless lithography technologies, and more particularly to a rapid scanning exposure method based on DMD.

### BACKGROUND

Maskless lithography is a technology for transferring an exposure pattern onto photosensitive material for imaging by using a spatial light modulator (SLM).

DMD (Digital Micro Mirror Device), as one of spatial light modulators, is widely used in maskless lithography systems. The DMD is an array of micro mirrors. The micro mirrors are independently controlled by a memory below the micro mirrors, each of which corresponds to one pixel in the image. When the data in the memory is 1, the micro mirrors may deflect an angle of + Θ, which corresponds to an open state; when the data in the memory is 0, the micro mirrors may deflect an angle of - Θ, which corresponds to a closed state. An angle of Θ is related to components of the DMD, and its typical value is 12 degrees or 17 degrees. In addition, each micro mirror may make its angle of deflection to 0 degree by a leveling command.

Scanning exposure is achieved as strip scanning exposure by using a uniform motion of a platform and refreshing the pattern with a certain scanning step. Compared with stepping exposure, the scanning exposure may effectively reduce splicing and improve the productivity.

In a scanning exposure process, when a precision platform moves from a starting point to an end point of each scanning step, the pattern is not refreshed, but a laser is turned on, causing "smearing", which further causes lines with the same line width, parallel and vertical to the scanning direction, to have line width differences, and ultimately limits the increasing in the scanning step. From the scanning speech being a product of a refresh frequency and the scanning step, it may be seen that, under a case of a certain pattern refresh frequency, the increasing in the scanning speed is limited by the scanning step, which ultimately affects the improvement in the productivity of the scanning exposure systems.

### SUMMARY

The disclosure seeks to solve at least one of the problems existing in the related art to at least some extent.

In view of this, the disclosure proposes a scanning exposure method, which may effectively reduce occurrences of "smearing" phenomenon and greatly increase the scanning speed.

The rapid scanning exposure method based on a DMD according to embodiments of the disclosure may be applicable for an exposure device. The exposure device includes a laser, the DMD, an objective lens, a substrate, and a precision platform. The scanning exposure method includes the following operations. At S100, light emitted by the laser is controlled to irradiate onto the DMD, to be reflected through the DMD into the objective lens, and to be imaged on photosensitive material on the substrate on the precision platform; at S200, the precision platform is controlled to make a uniform motion in a first direction and to generate pulse signals equidistantly with a set scanning step, and to make a stepping or not make a motion in a second direction perpendicular to the first direction; at S300, an angle of deflection of micro mirrors of the DMD is adjusted after a pattern is refreshed when the DMD detects the pulse signal and before a next pulse signal is detected, to reflect the light emitted by the laser outside the objective lens.

With the scanning exposure method of the embodiments of the disclosure, the angle of deflection of the micro mirrors of the DMD is adjusted after the pattern is refreshed when the micro mirrors of the DMD detects the pulse signal and before the next pulse signal is detected, such that the light emitted by the laser is reflected outside the objective lens, and cannot be imaged on the photosensitive material on the substrate when the precision platform scans and moves in the first movement direction. This method effectively reduces the effect of "smearing" in the scanning exposure process on the line width difference of the lines with the same line width in different directions, which may greatly increase the scanning step and reduce requirements on the refresh frequency of the micro mirrors of the DMD. Furthermore, the scanning speed and productivity of the scanning exposure device may be improved.

According to an embodiments of the disclosure, the pulse signal is low level or high level.

According to an embodiments of the disclosure, the micro mirrors of the DMD start to refresh the pattern when detecting a rising edge or a falling edge of the pulse signal.

According to an embodiments of the disclosure, the scanning step of the precision platform is not greater than an effective display height of the micro mirrors of the DMD after being imaged on the substrate.

According to an embodiments of the disclosure, after refreshing the pattern when the DMD detects the pulse signal of the precision platform, and before the next pulse signal of the precision platform is detected, a delay duration of adjusting the angle of deflection of the micro mirrors of the DMD to reflect the light emitted by the laser outside the objective lens, is adjustable.

According to an embodiments of the disclosure, the DMD includes a micro-mirror body, in which the micro-mirror body is switchable between an open state and a closed state, the micro-mirror body is configured to reflect the light emitted by the laser into the objective lens when the micro-mirror body is under the open state, and to reflect the light emitted by the laser outside the objective lens when the micro-mirror body is under the closed state; and a memory configured to control the angle of deflection of the micro-mirror body, and to control the micro-mirror body to switch between the open state and the closed state based on a result of stored data.

According to an embodiments of the disclosure, the memory has stored data 1 and data 0, and a method of refreshing the pattern by the DMD includes: when the memory detects the pulse signal and has stored the data 1, activating the micro-mirror body to the open state; when the memory detects the pulse signal and has stored the data 0, activating the micro-mirror body to the closed state.

According to an embodiments of the disclosure, when the micro-mirror body is under the open state, the angle of deflection of the micro-mirror body is an angle of +Θ; and when the micro-mirror body is under the closed state, the angle of deflection of the micro-mirror body is an angle of -Θ.

According to an embodiments of the disclosure, the micro-mirror body further includes a leveling state. When the micro-mirror body is under the leveling state, the angle of deflection of the micro-mirror body is an angle of 0, and the micro-mirror body reflects the light emitted by the laser outside the objective lens.

According to an embodiments of the disclosure, a method of reflecting the light emitted by the laser through the micro-mirror body outside the objective lens includes: activating the micro-mirror body to the leveling state through the DMD based on a leveling command, or activating the micro-mirror body to the leveling state by loading the data 0 into the memory.

Additional aspects and advantages of embodiments of the disclosure will be given in part in the following descriptions, become apparent in part from the following descriptions, or be learned from the practice of the embodiments of the disclosure.

### BRIEF DESCRIPTION OF THE DRAWINGS

These and other aspects and advantages of embodiments of the disclosure will become apparent and more readily appreciated from the following descriptions made with reference to the accompanying drawings.
FIG. 1 is a flow chart illustrating a scanning exposure method according to an embodiment of the disclosure;
FIG. 2 is a schematic diagram illustrating an exposure device in a scanning exposure method according to an embodiment of the disclosure;
FIG. 3 is a schematic diagram illustrating a pulse signal sent by a precision platform in a scanning exposure method according to an embodiment of the disclosure;
FIG. 4 is a schematic diagram illustrating a state of a micro-mirror body of a DMD in a scanning exposure method according to an embodiment of the disclosure;
FIG. 5 is a schematic diagram illustrating a scanning strip pattern in a scanning exposure method according to an embodiment of the disclosure;
FIG. 6 is a schematic diagram of a display process of the scanning strip pattern in FIG. 5 on a DMD.
FIG. 7 is a schematic diagram of an imaging process of the scanning strip pattern in FIG. 5 on photosensitive material on a substrate.

### Reference numerals:

Exposure device 10; laser 11; DMD 12; objective lens 13; substrate 14; precision platform 15.

### DETAILED DESCRIPTION

Reference will be made in detail to embodiments of the disclosure. Examples of the embodiments are illustrated in the drawings, in which the same or similar elements and the elements having same or similar functions are denoted by like reference numerals throughout the descriptions. The embodiments described below with reference to the drawings are exemplary, and used to explain the disclosure, and shall not be construed to limit the disclosure.

In the specification of the disclosure, it should be understood that the terms such as "central", "upper", "lower", "front", "rear", "left", "right", "vertical", "horizontal", "top", "bottom", "inner", "outer", refer to the directions and location relations which are the directions and location relations shown in the drawings, and for describing the disclosure and for describing in simple, and which are not intended to indicate or imply that the device or the elements are disposed to locate at the specific directions or are structured and performed in the specific directions, which could not to be understood to the limitation of the disclosure.

It should be noted that terms such as "first" and "second" are used herein for purposes of description and are not intended to indicate or imply relative importance or significance. Furthermore, the feature defined with "first" and "second" may comprise one or more this feature distinctly or implicitly. In the description of the present disclosure, "a plurality of' means two or more than two, unless specified otherwise.

The scanning exposure method according to an embodiment of the disclosure will be described in detail below with reference to the drawings.

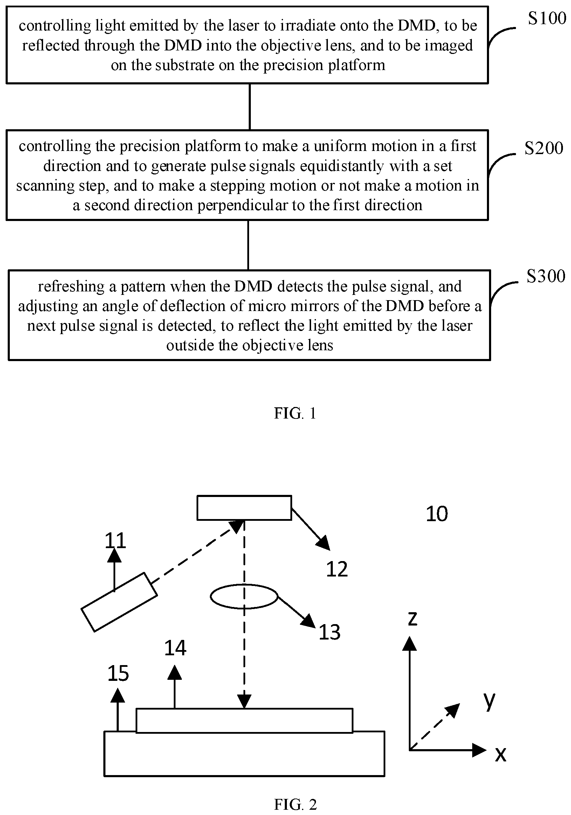

It should be noted that the scanning exposure method according to an embodiment of the disclosure may be applicable for the exposure device 10 illustrated in FIG. 2. The exposure device 10 includes a laser 11, a DMD 12, an objective lens 13, a substrate 14, and a precision platform 15. Light irradiates onto the DMD 12 through the laser 11 and is reflected through the DMD 12 into the objective lens 13, and finally is imaged on photosensitive material such as a silicon wafer on the substrate 14 on the precision platform 15.

As illustrated in FIG. 1, the scanning exposure method according to an embodiment of the disclosure includes the following operations.

At S100, light emitted by the laser 11 is controlled to irradiate onto the DMD 12, to be reflected through the DMD 12 into the objective lens 13, and to be imaged on photosensitive material on the substrate 14 on the precision platform 15.

At S200, the precision platform 15 is controlled to make a motion in a first direction and to generate pulse signals equidistantly with a set scanning step, and to make a stepping motion or not make a motion in a second direction perpendicular to the first direction.

At S300, an angle of deflection of micro mirrors of the DMD 12 is adjusted after a pattern is refreshed when the DMD 12 detects the pulse signal and before a next pulse signal is detected, to reflect the light emitted by the laser outside the objective lens 13.

In other words, when scanning and exposing the strip pattern that needs to be scanned, the scanning exposure method according to the embodiments of the disclosure firstly controls the laser 11 to be turned on, the light irradiates onto the DMD 12 and is reflected through the DMD 12 into the objective lens 13, and is imaged on the photosensitive material on the substrate 14 on the precision platform 15; then during the exposure process, the precision platform 15 is controlled to make the uniform motion in the first direction (the y-direction illustrated in FIG. 2) and to generate the pulse signals based on the set scanning step in the first direction, and then the precision platform 15 is controlled to make the stepping motion or not make the motion along the second direction (the x-direction illustrated in FIG. 2), corresponding to a plurality of scannings and one scanning, respectively. For the plurality of scannings, at the end of one scanning motion in the first direction, the precision platform 15 makes the stepping motion in the second direction, and then triggers pulse signals equidistantly along an opposite direction of the first direction, and then reciprocates in sequence. For one scanning, the precision platform 15 only triggers pulse signals equidistantly in the first direction until the end of the scanning.

The DMD 12 detects the pulse signals sent by the precision platform 15 in real time during the movement of the precision platform 15. When the DMD 12 detects the pulse signal, the DMD 12 refreshes the pattern based on the data in the memory. When the data in the memory is 1, the micro mirrors of the DMD 12 deflect an angle of + Θ, which corresponds to an open state; when the data in the memory is 0, the micro mirrors of the DMD 12 deflect an angle of - Θ, which corresponds to a closed state. After the pattern is refreshed and before the next pulse signal of the precision platform 15 is detected, the angle of deflection of the micro mirrors of the DMD 12 is adjusted to reflect the light emitted by the laser outside the objective lens 13 to avoid that the "smearing" occurs in the process of the scanning movement of the precision platform 15 in the first direction.

Thus, with the scanning exposure method of the embodiments of the disclosure, the angle of deflection of the micro mirrors of the DMD 12 is adjusted after the pattern is refreshed when the DMD 12 detects the pulse signal and before the next pulse signal is detected, such that the light emitted by the laser is reflected outside the objective lens 13, and cannot be imaged on the photosensitive material on the substrate 14 when the precision platform 15 scans and moves in the first movement direction. This method effectively reduces the effect of "smearing" in the scanning exposure process on the line width difference of the lines with the same line width in different directions, which may greatly increase the scanning step and reduce requirements on the refresh frequency of the micro mirrors of the DMD. Furthermore, the scanning speed and productivity of the scanning exposure device may be improved.

According to an embodiments of the disclosure, the DMD 12 starts to refresh the pattern when detecting a rising edge or a falling edge of the pulse signal. The pulse signal is low level or high level.

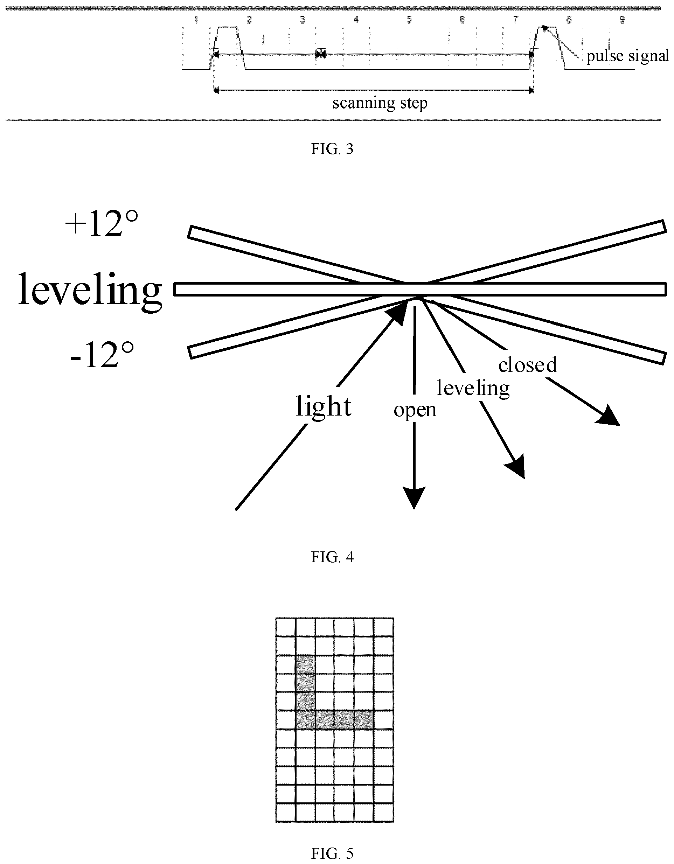

In detail, as illustrated in FIG. 3, FIG. 3 illustrates a relationship between a timing of sending the pulse signal by the precision platform 15 and the scanning step. When the precision platform 15 moves in the first direction, it may trigger the pulse signal just starts the movement, and then trigger pulse signals equidistantly in the first direction according to the scanning step. For the plurality of scannings, at the end of one scanning motion in the first direction, the precision platform 15 makes the stepping motion in the second direction, and then triggers pulse signals equidistantly along an opposite direction of the first direction, and then reciprocates in sequence. For one scanning, the precision platform 15 only triggers pulse signals equidistantly in the first direction until the end of the scanning.

According to an embodiments of the disclosure, the DMD 12 includes a micro-mirror body and a memory.

The micro-mirror body is switchable between the open state and the closed state. The micro-mirror body may reflect the light emitted by the laser 11 into the objective lens 13 when the micro-mirror body is under the open state, and the micro-mirror body may reflect the light emitted by the laser 11 outside the objective lens 13 when the micro-mirror body is under the closed state. The memory is configured to control the angle of deflection of the DMD 12. The memory may control the micro-mirror body to switch between the open state and the closed state based on a result of stored data.

Alternatively, the memory has stored data 1 and data 0. The method of refreshing the pattern by the DMD 12 includes: when the memory detects the pulse signal and has stored the data 1, activating the micro-mirror body to the open state; and when the memory detects the pulse signal and has stored the data 0, activating the micro-mirror body to the closed state. Furthermore, when the micro-mirror body is under the open state, the angle of deflection of the micro-mirror body is an angle of +12 degrees; and when the micro-mirror body is under the closed state, the angle of deflection of the micro-mirror body is an angle of -12 degrees.

In other words, the active state of the micro-mirror body may be independently controlled by the memory. The memory is located below the micro-mirror body. The memory may control the angle of the micro-mirror body based on the loaded data to reflect the light emitted by the laser into the objective lens 13 or outside the objective lens 13. In detail, when the memory located below the micro mirrors of the DMD is 1, the micro-mirror body deflects the angle of +12 degrees, and is under the open state, and the light emitted by the laser is reflected to the photosensitive material on the substrate 14 of the precision platform 15 for imaging; when the memory located below the micro mirrors of the DMD is 0, the micro-mirror body deflects the angle of -12 degrees, and is under the closed state, and the light emitted by the laser is reflected outside the objective lens 13.

According to an embodiments of the disclosure, the micro-mirror body further includes a leveling state. When the micro-mirror body is under the leveling state, the angle of deflection of the micro-mirror body is an angle of 0, and the micro-mirror body reflects the light emitted by the laser outside the objective lens 13. Furthermore, the method of reflecting the light emitted by the laser through the DMD 12 outside the objective lens 13, includes: activating the micro-mirror body to the leveling state through the DMD 12 based on a leveling command.

In other words, in addition to activating the micro-mirror body to the closed state by loading the data 0 through the memory, the memory may also send the leveling command directly to the micro-mirror body such that the angle of deflection of the micro-mirror body is the angle of 0. At this time, the light emitted by the laser may also be reflected outside the objective lens 13 by the micro-mirror body, and this state is similar to the closed state of the micro-mirror body.

In detail, as illustrated in FIG. 4, the micro-mirror body may be movable among the open state, the leveling state and the closed state. When the micro-mirror body is under the open state, the angle of deflection of the micro-mirror body is the angle of +12 degrees. When the micro-mirror body is under the closed state, the angle of deflection of the micro-mirror body is the angle of -12 degrees. When the micro-mirror body is under the leveling state, the angle of deflection of the micro-mirror body is the angle of 0.

Preferably, in some embodiments of the disclosure, the memory sends a shutdown command or a leveling command to the micro-mirror body after a predetermined delay after the DMD 12 refreshes the pattern. In other words, the shutdown command or the leveling command of the micro mirrors of the DMD may be sent after a period of time after the DMD 12 refreshes the pattern. The delay may be determined by the settling time of the micro mirrors of the DMD.

According to an embodiments of the disclosure, the scanning step of the precision platform 15 is not greater than the effective display height of the DMD 12. The effective display height of the DMD 12 refers to the projection height when the actual display height of the DMD 12 is projected onto the focal plane of the platform substrate after being enlarged or reduced by the optical system.

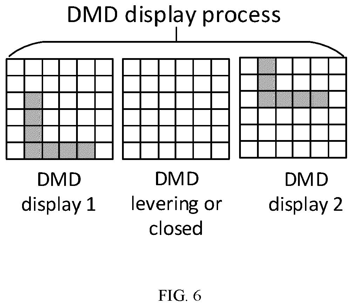

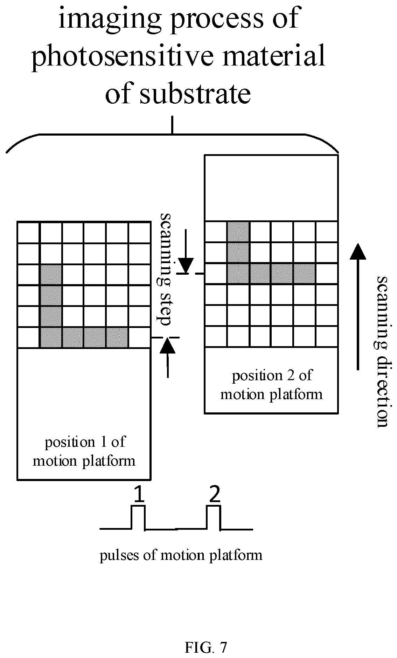

The application of the scanning exposure method according to an embodiment of the present disclose when scanning a strip pattern is described in detail below with reference to FIGS. 5 to 7.

In the scanning exposure method according to the embodiments of the disclosure, a size of the micro-mirror array of the DMD is 6 × 6, a magnification of the objective lens is 1, and the scanning step is 3 heights of the micro mirrors of the DMD. The micro mirrors of the DMD may refresh under pulse 1 and pulse 2 of the precision platform respectively, and performs a shutdown or a leveling operation between pulse 1 and pulse 2 to reflect the light emitter by the laser outside the objective lens 13. The photosensitive material on the substrate on the precision platform may image at the position of the platform corresponding to pulse 1 and pulse 2, and may not image between pulse 1 and pulse 2, avoiding "smearing".

Therefore, with the scanning exposure method of the embodiments of the disclosure, the angle of deflection of the micro mirrors of the DMD is adjusted by turning off or by leveling between the two pulse signals of the precision platform, so that the light emitted by the laser is reflected outside the objective lens, reducing the line width difference of the lines with the same line width in different directions, the difference being caused by "smearing" of lines perpendicular to the scanning direction. When the micro mirrors of the DMD is closed or leveled, the "smearing" will no longer be positively correlated with the scanning step. At this time, the scanning step may be greatly increased, but does not exceed the height of the effective display area of the DMD, thereby achieving the effects of lower DMD refresh frequency, higher scanning speed, and higher productivity.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the disclosure. Furthermore, the particular features, structures, materials, or characteristics may be combined in any suitable manner in one or more embodiments or examples.

Although explanatory embodiments have been shown and described, it would be appreciated by those skilled in the art that the above embodiments cannot be construed to limit the disclosure, and changes, alternatives, and modifications can be made in the embodiments without departing from spirit, principles and scope of the disclosure.

## Claims

1. A rapid scanning exposure method based on a digital micro mirror device (DMD), applicable for an exposure device, the exposure device comprising a laser, the DMD, an objective lens, a substrate, and a precision platform, and the scanning exposure method comprising the following operations:
S100, controlling light emitted by the laser to irradiate onto the DMD, to be reflected through the DMD into the objective lens, and to be imaged on the substrate on the precision platform;
S200, controlling the precision platform to make a uniform motion in a first direction and to generate pulse signals equidistantly with a set scanning step, and to make a stepping motion or not make a motion in a second direction perpendicular to the first direction;
S300, refreshing a pattern when the DMD detects the pulse signal, and adjusting an angle of deflection of micro mirrors of the DMD before a next pulse signal is detected, to reflect the light emitted by the laser outside the objective lens.

2. The method of claim 1, wherein the pulse signal of the precision platform is low level or high level.

3. The method of claim 1, wherein the DMD starts to refresh the pattern when detecting a rising edge or a falling edge of the pulse signal.

4. The method of claim 1, wherein the scanning step of the precision platform is not greater than an effective display height of the DMD after the DMD is imaged on the substrate.

5. The method of claim 1, wherein after refreshing the pattern when the DMD detects the pulse signal of the precision platform, and before the next pulse signal of the precision platform is detected, a delay duration of adjusting the angle of deflection of the micro mirrors of the DMD to reflect the light emitted by the laser outside the objective lens, is adjustable.

6. The method of claim 1, wherein the DMD comprises:
a micro-mirror body, in which the micro-mirror body is switchable between an open state and a closed state, the micro-mirror body is configured to reflect the light emitted by the laser into the objective lens when the micro-mirror body is under the open state, and to reflect the light emitted by the laser outside the objective lens when the micro-mirror body is under the closed state; and
a memory configured to control the angle of deflection of the micro-mirror body, and to control the micro-mirror body to switch between the open state and the closed state based on a result of stored data.

7. The method of claim 6, wherein the memory has stored data 1 and data 0, and a method of refreshing the pattern by the DMD comprises:
when the memory detects the pulse signal and has stored the data 1, activating the micro-mirror body to the open state; and
when the memory detects the pulse signal and has stored the data 0, activating the micro-mirror body to the closed state.

8. The method of claim 7, wherein when the micro-mirror body is under the open state, the angle of deflection of the micro-mirror body is an angle of +Θ; and when the micro-mirror body is under the closed state, the angle of deflection of the micro-mirror body is an angle of -Θ.

9. The method of claim 8, wherein the micro-mirror body further comprises a leveling state; and when the micro-mirror body is under the leveling state, the angle of deflection of the micro-mirror body is an angle of 0, and the micro-mirror body reflects the light emitted by the laser outside the objective lens.

10. The method of claim 6, wherein a method of reflecting the light emitted by the laser through the micro-mirror body outside the objective lens comprises:
activating the micro-mirror body to the leveling state through the DMD based on a leveling command, or activating the micro-mirror body to the leveling state by loading the data 0 into the memory.
